# EUROPÄISCHE PATENTSCHRIFT

(11) **EP 2 242 344 B1**
(45) Veröffentlichungstag und Bekanntmachung des Hinweises auf die Patenterteilung: **11.05.2011**
(21) Anmeldenummer: 09158167.8
(22) Anmeldetag: 17.04.2009
(51) Int. Cl.: H05K 7/20, H02K 5/18

(54) **Elektronikgehäuse mit partiellem Kühlkörper**
Electronics housing with partial cooling body
Boîtier électronique doté d'un corps de refroidissement partiel

(43) Veröffentlichungstag der Anmeldung: 20.10.2010
(73) Patentinhaber: ebm-papst Mulfingen GmbH & Co. KG, 74673 Mulfingen (DE)
(72) Erfinder: Best, Dieter, 74653 Ingelfingen (DE); Sauer, Thomas, 65510 Idstein (DE); Lipp, Helmut, 74677 Dörzbach-Hohebach (DE); Futterlieb, Gerd, 74423 Obersontheim (DE); Zierlein, Rainer, 97999 Igersheim (DE); Ehmann, Tobias, 74626 Bretzfeld Unterheimbach (DE)
(74) Vertreter: Patentanwälte Dr. Solf & Zapf

(56) Entgegenhaltungen:
- EP-A- 1 006 766
- EP-A- 1 270 167
- DE-A1- 4 224 720
- US-B1- 6 704 202

## Beschreibung

Die Erfindung betrifft ein Elektronikgehäuse für einen Elektromotor, bestehend aus einem mit dem Elektromotor verbindbaren Gehäuseunterteil, einer in dem Elektronikgehäuse angeordneten Leiterplatte und einem auf dem Gehäuseunterteil aufgesetzten Gehäuseoberteil, wobei in dem Elektronikgehäuse mindestens eine Öffnung für einen im Elektronikgehäuse angeordneten Kühlkörper für ein elektronisches Bauelement vorgesehen ist und die Öffnung im Gehäuseoberteil angeordnet ist und insbesondere das Gehäuseoberteil aus Kunststoff gefertigt ist, wobei das Gehäuseoberteil eine Stirnwand und eine umlaufende Seitenwandung besitzt. Weiterhin bezieht sich die Erfindung auf einen mit einem derartigen Elektronikgehäuse versehenen Elektromotor.

Elektronikgehäuse der eingangs beschriebenen Art werden bei Elektromotoren verwendet, um die elektronische Steuereinheit aufzunehmen und die elektrischen Anschlussleitungen und die Motorspulen an die elektronische Steuereinheit anzuschließen, wobei die Wärme, die innerhalb des Elektronikgehäuses erzeugt wird, abgeleitet werden soll.

In der US 5,969,445 ist ein solches Elektronikgehäuse beschrieben, wobei hier die Kühlung durch einen in das Gehäuseunterteil eingebauten Kühlkörper erfolgt. Das zu kühlende elektronische Bauteil wird durch eine Federklemme gegen eine senkrecht zu der Grundplatte des Kühlkörpers verlaufende Anlagefläche des Kühlkörpers gedrückt. Ein Nachteil dieser Anordnung ist, dass dies zu einer zur Motorachse radialen Vergrößerung der Bauweite des Elektronikgehäuses führt, da die Öffnung außerhalb des vom Stator bzw. Läufer verdeckten Bereichs des Gehäuseunterteils liegen muss, um einen guten Wärmeaustausch des Kühlkörpers mit der Umgebungsluft zu bewirken. Außerdem ist die Montage kompliziert, da das elektronische Bauteil durch ein Federelement an den Kühlkörper angedrückt werden muss und sich die elektronischen Bauelemente auf der dem Stator zugewandten Seite der Leiterplatte befinden.

In der EP 1 006 766 A2 ist eine elektronische Vorrichtung mit einem zweigeteilten Gehäuse zur Aufnahme eines, eine elektronische Schaltung tragenden Trägersubstrates beschrieben, wobei ein Kühlkörper an der äußeren Seite eines Gehäuseteils angeordnet ist. Diese Ausgestaltung hat den Nachteil, dass der Kühlkörper über den stirnseitigen Gehäuserand herausragt und somit seitlich versetzt zu einem Stator eines an der Stirnseite angebrachten Elektromotors verlaufen müsste. Dies würde ebenfalls zu einer zur Motorachse radialen Vergrößerung der Bauweite des Elektronikgehäuses führen.

Der Erfindung liegt daher die Aufgabe zugrunde, ein Elektronikgehäuse für einen Elektromotor zu schaffen, das es ermöglicht, die elektrischen Bauteile auf der im Gehäuse angeordneten Leiterplatte effektiv zu kühlen, gleichzeitig eine kompakte Bauform zu ermöglichen, die Montage zu vereinfachen und Materialkosten einzusparen.

Bei einem Elektronikgehäuse der eingangs beschriebenen Art wird die Aufgabe erfindungsgemäß dadurch gelöst, dass die Öffnung im Gehäuseoberteil angeordnet ist, das insbesondere aus Kunststoff gefertigt ist und von einem Kühlkörper durchgriffen wird. Die Fertigung aus Kunststoff ermöglicht eine leichtere und kostengünstigere Bauweise. Dadurch, dass die Öffnung im Gehäuseoberteil angeordnet ist, muss das Elektronikgehäuse nicht mehr über die radiale Weite des Stators hinausgehen, um eine gute Kühlung mit der Umluft zu ermöglichen. Das hat den Vorteil, dass das Elektronikgehäuse in seiner radialen Weite minimiert werden kann. Dies kann zusätzlich Material einsparen und die Kosten senken. Außerdem wird die Montage der Leiterplatte vereinfacht, da alle zu kühlenden elektronischen Bauteile auf der dem Stator abgewandten Seite der Leiterplatte positioniert werden können. Die Leiterplatte kann so einfach montiert und angeschlossen werden, und das Gehäuseoberteil und die Leiterplatte können vormontiert und als Vormontageeinheit später mit dem Gehäuseunterteil verbunden werden.

In einer Ausführungsform der Erfindung hat das Gehäuseoberteil, welches eine Stirnwand und eine umlaufende Seitenwandung besitzt, auf der inneren Seite der Stirnwand einen in den Innenraum ragenden domartigen Fortsatz, wobei sich die zur Aufnahme des Kühlkörpers dienende Öffnung in der Stirnseite des Fortsatzes befindet. Zur weiteren Ausgestaltung der Erfindung besitzt der Kühlkörper eine Grundplatte und ist auf der dem Gehäuseoberteil zugewandten Seite mit senkrecht zur Grundplatte verlaufenden Kühlrippen versehen, die in die Öffnung des Fortsatzes hineinragen. Dies hat den Vorteil, dass der Kühlkörper nicht über die lichte Höhe des Gehäuseoberteils hinausragt und gleichzeitig die Höhe der Kühlrippen vergrößert und damit die Kühlwirkung verbessert wird. Außerdem ist an dem Kühlkörper auf seiner dem Gehäuseoberteil abgewandten Seite der Grundplatte eine Anlagefläche zur Wärmeübertragung ausgebildet. Der Kühlkörper wird durch die Verbindung des Gehäuseoberteils mit der Leiterplatte mit seiner Anlagefläche, bzw. zur noch weiter verbesserten Wärmeübertragung, mittels eines Wärmeleit-Pad, an das zu kühlende elektronische Bauteil gedrückt. Somit kann eine weitere Maßnahme, wie zum Beispiel eine Halteklammer zum Befestigen des Kühlkörpers mit dem elektronischen Bauteil, eingespart werden und die Montage weiter vereinfacht werden.

In einer Ausgestaltung der Erfindung weist der Kühlkörper bevorzugt mindestens einen Halteflansch mit mindestens einer Anlagefläche zur Befestigung von mindestens einem elektronischen Bauteil auf, der seitlich an der Grundplatte mit einem seitlichen Abstand zu den Kühlrippen senkrecht zur Leiterplatte angeformt ist, so dass er seitlich versetzt zur Öffnung innerhalb des Gehäuseoberteils verläuft. Dabei kann in dieser Ausführungsform der Erfindung das elektronische Bauteil auch fest mit der Leiterplatte verlötet und der Halteflansch so positioniert sein, dass durch Verspannungskräfte, die durch eine leicht versetzte Positionierung des elektronischen Bauteils auf der Leiterplatte relativ zum Halteflansch in den Kontaktstiften des elektronischen Bauteils bewirkt werden, das elektronische Bauteil bei der Vormontage der Leiterplatte mit seiner Kühlfläche an die Anlagefläche des Halteflansches des Kühlkörpers gedrückt wird.

Diese Ausführung hat den Vorteil, dass in einfacher Weise auch mehrere elektronische Bauteile durch einen Kühlkörper gekühlt werden können, und weiterhin der Kühlkörper in sehr einfacher und kostengünstiger Weise montiert und mit den elektronischen Bauteilen verbunden werden kann und ermöglicht ebenfalls eine kleinere Bauweise des Elektronikgehäuses.

Weitere Einzelheiten, Merkmale und Vorteile des Gegenstandes der Erfindung ergeben sich aus den Unteransprüchen sowie aus der nachfolgenden Beschreibung der zugehörigen Zeichnungen, in der - beispielhaft - zwei bevorzugte Ausführungsbeispiele der Erfindung dargestellt sind. Es zeigen:
- Fig. 1: eine dreidimensionale Darstellung eines zusammengebauten erfindungsgemäßen Elektronikgehäuses,
- Fig. 2: eine dreidimensionale Darstellung eines Gehäuseoberteils mit Kühlkörper und Wärmeleit-Pad eines erfindungsgemäßen Elektronikgehäuses im nicht montierten Zustand,
- Fig. 3: eine dreidimensionale Darstellung einer Leiterplatte eines erfindungsgemäßen Elektronikgehäuses,

- Fig. 4: eine dreidimensionale Darstellung eines Gehäuseoberteils mit montierter Leiterplatte und eines nicht montierten Gehäuseunterteils einer zweiten Ausführung eines erfindungsgemäßen Elektronikgehäuses,
- Fig. 5: eine dreidimensionale Darstellung eines Gehäuseoberteils mit Kühlkörper und Wärmeleit-Pad einer zweiten Ausführungsform eines erfindungsgemäßen Elektronikgehäuses im nicht montierten Zustand,
- Fig. 6: eine dreidimensionale Darstellung einer zweiten Ausführungsform eines Kühlkörpers eines erfindungsgemäßen Elektronikgehäuses,
- Fig. 7: eine dreidimensionale Darstellung einer zweiten Ausführungsform einer Leiterplatte eines erfindungsgemäßen Elektronikgehäuses.

Gleiche Teile sind in den verschiedenen Figuren mit denselben Bezugsziffern gekennzeichnet.

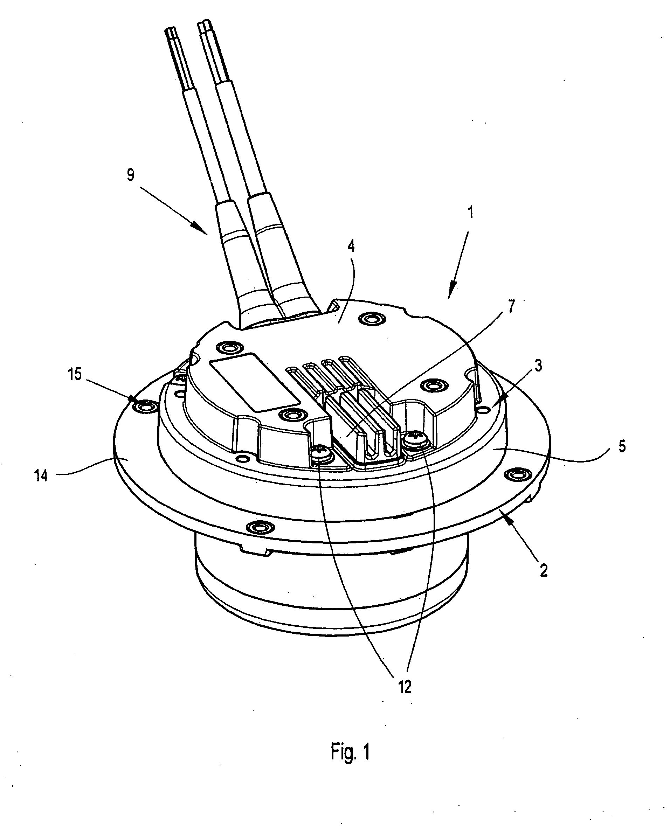

Fig. 1 zeigt ein zusammengebautes erfindungsgemäßes Elektronikgehäuse 1 für einen Elektromotor, insbesondere Außenläufermotor, bestehend aus einem mit dem Elektromotor verbindbaren, insbesondere aus Kunststoff gefertigten, Gehäuseunterteil 2 und einem auf dem Gehäuseunterteil 2 aufgesetzten aus Kunststoff gefertigten Gehäuseoberteil 3 mit einer Stirnwand 4 und einer umlaufenden Seitenwandung 5, wobei ein Kühlkörper 7 aus einer Öffnung des Gehäuseoberteils 3 herausragt. Zusätzlich befindet sich in der Stirnwand 4 des Gehäuseoberteils 3 eine Öffnung zum Anschließen elektrischer Anschlussleitungen 9. In der Stirnwand 4 befinden sich Montagelöcher 10 zum Verschrauben des Gehäuseoberteils 3 mit dem Gehäuseunterteil 2 mittels Schraubverbindungen 12. Das Gehäuseunterteil 2 bildet an seinem Umfang einen Statorflansch 14 mit Bohrungen 15 zum Anschrauben des Gehäuseunterteils 2 an eine nicht dargestellte Motorhalterung.

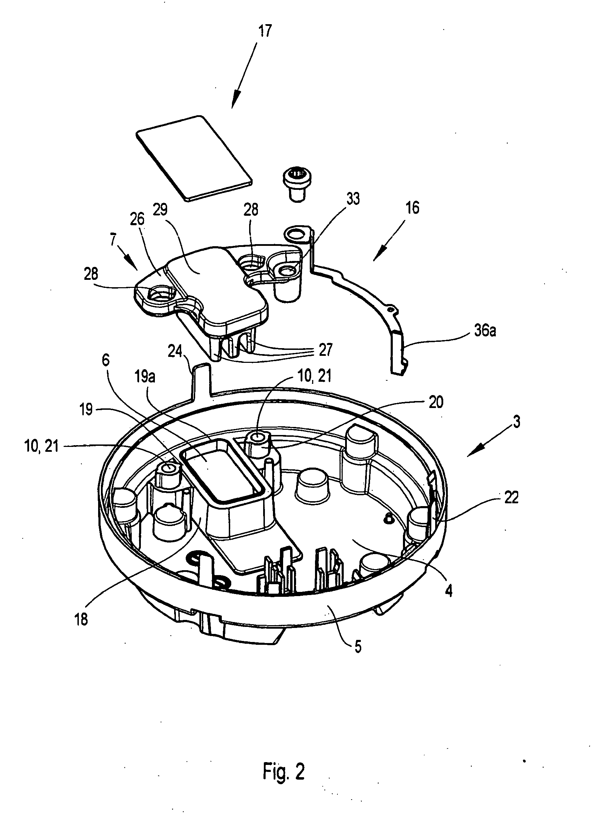

Fig. 2 zeigt ein erfindungsgemäßes Gehäuseoberteil 3 mit dem noch nicht eingebauten Kühlkörper 7, einem Schutzerde-Anschluss 16 und einem noch nicht endgültig positionierten Wärmeleit-Pad 17. In dem becherförmigen Gehäuseoberteil 3 ist auf der inneren Seite der Stirnwand 4 ein in den Innenraum des Gehäuseoberteils 3 ragender domartiger Fortsatz 18 ausgebildet, wobei sich eine Öffnung 6 zur Aufnahme eines Kühlkörpers 7 in einer Stirnseite 19 des Fortsatzes 18 befindet. Zusätzlich befinden sich auf der inneren Seite der Stirnwand 4 über zwei der Montagelöchern 10 zwei domartige Ansätze 20 mit Durchgangsbohrungen 21 zum Verbinden des Gehäuseunterteils mit dem Gehäuseoberteil 3 mittels der Schraubverbindungen 12, wobei die Ansätze 20 zur Positionierung des Kühlkörpers 7 in der Öffnung 6 und zum Aufstecken des Kühlkörpers 7 auf das Gehäuseoberteil 3 dienen, sodass der Kühlkörper 7 aus der Öffnung 6 des Gehäuseoberteils 3 herausragt. Die Montagelöcher 10 können an der inneren Stirnfläche nicht dargestellte, halbkreisförmige Laschen als Fügehilfen besitzen. Der Fortsatz 18 weist an seiner dem Kühlkörper 7 zugewandten Stirnseite 19 eine angespritzte Dichtung 19a, insbesondere aus elastischem Kunststoff, auf. Außerdem befindet sich an der Seitenwandung 5 des Gehäuseoberteils 3 mindestens ein lösbarer Rastarm 22. Zusätzlich können sich an der Seitenwandung 5 des Gehäuseoberteils 3 mehrere Führungslaschen 24 befinden. Der Kühlkörper 7 besteht aus einer Grund-platte 26 und auf der dem Gehäuseoberteil 3 zugewandten Seite senkrecht zur Grund-platte 26 verlaufenden Kühlrippen 27, wobei die Höhe der Kühlrippen 27 kleiner als die Höhe des Fortsatzes 18 ist, so dass die Kühlrippen 27 nicht über die Außenseite der Stirnwand 4 des Gehäuseoberteils 3 hinausragen können. Die Grundplatte 26 weist zwei Löcher 28 auf, wobei der Kühlkörper 7 mittels der Löcher 28 auf die Ansätze 20 des Gehäuseoberteils 3 aufgesteckt wird. Der Kühlkörper 7 hat auf seiner dem Gehäuseoberteil 3 abgewandten Seite der Grundplatte 26 eine Anlagefläche 29 zur Wärmeübertragung.

Alternativ zur angespritzten Dichtung 19a auf dem Fortsatz 18 kann der Kühlkörper 7 auf seiner dem Gehäuseoberteil 3 zugewandten Seite der Grundplatte 26 eine um die Kühlrippen 27 verlaufende Dichtfläche 30 zum Abdichten der Öffnung 6 mit der Stirnfläche 19 des Fortsatzes 18 des Gehäuseoberteils 3 aufweisen. Die Dichtfläche 30 kann eine um die Kühlrippen 27 verlaufende Dichtnut 31 zur Aufnahme einer nicht dargestellten O-Ring Dichtung haben, welche an der Stirnseite 19 des Fortsatzes 18 anliegt. Außerdem weist die Grundplatte 26 eine Bohrung 33 zum Befestigen des bogenförmigen Schutzerde-Anschlusses 16 durch eine Schraube auf. Das Wärmeleit-Pad 17 wird auf der Anlagefläche 29 der Grundplatte 26 des Kühlkörpers 7, insbesondere durch eine Klebeverbindung, befestigt.

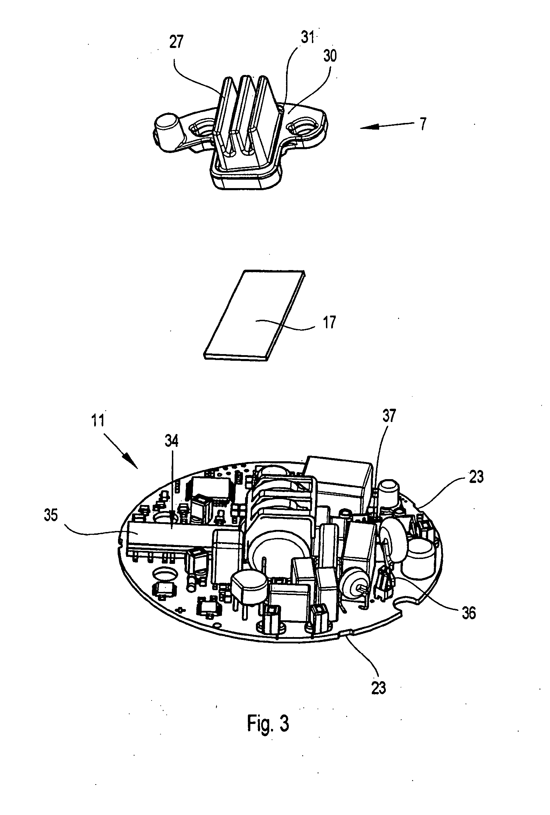

Fig. 3 zeigt einen erfindungsgemäßen Kühlkörper 7 und eine Leiterplatte 11 des Elektronikgehäuses 1 mit mindestens einem, an der dem Gehäuseoberteil 3 zugewandten Seite der Leiterplatte 11 angebrachten, zu kühlenden elektronischen Bauteil 34. Die Leiterplatte 11 weist an ihrem Umfang mehrere Aussparungen 23 zur Aufnahme der Rastarme 22 des Gehäuseoberteils 3 auf, die so positioniert sind, dass das zu kühlende elektronische Bauteil 34 mit seiner Kühlfläche 35 genau an der Anlagefläche 29 des im Gehäuseoberteil 3 befestigten Kühlkörpers 7 bzw. an dem darauf befestigten Wärmeleit-Pad 17 anliegt. Außerdem weist die Leiterplatte 11 einen Anschlusskontakt 36 zur Aufnahme eines Steckerstiftes 36a des Schutzerde-Anschlusses 16 des Kühlkörpers 7 auf. Zusätzlich befindet sich auf der Leiterplatte 11 auch eine Kontaktierung 37 mit mehreren Pins zur Verbindung der elektrischen Anschlussleitungen 9.

Wie weiter oben bereits angesprochen, greift der Rastarm 22 des Gehäuseoberteils 3 in die Aussparung 23 der Leiterplatte 11 zum Zweck der Positionierung der Leiterplatte 11 gegenüber dem Gehäuseoberteil 3 und zum Verbinden des Gehäuseoberteils 3 mit der Leiterplatte 11 ein, sodass die Leiterplatte 11, der Kühlkörper 7, das Wärmeleit-Pad 17 und das Gehäuseoberteil 3 eine Vormontageeinheit bilden können und dabei die Leiterplatte 11 gegen den Kühlkörper 7 anliegt. Die Führungslaschen 24 dienen als Fügehilfe bei der Endmontage der Vormontageeinheit mit dem Gehäuseunterteil 2.

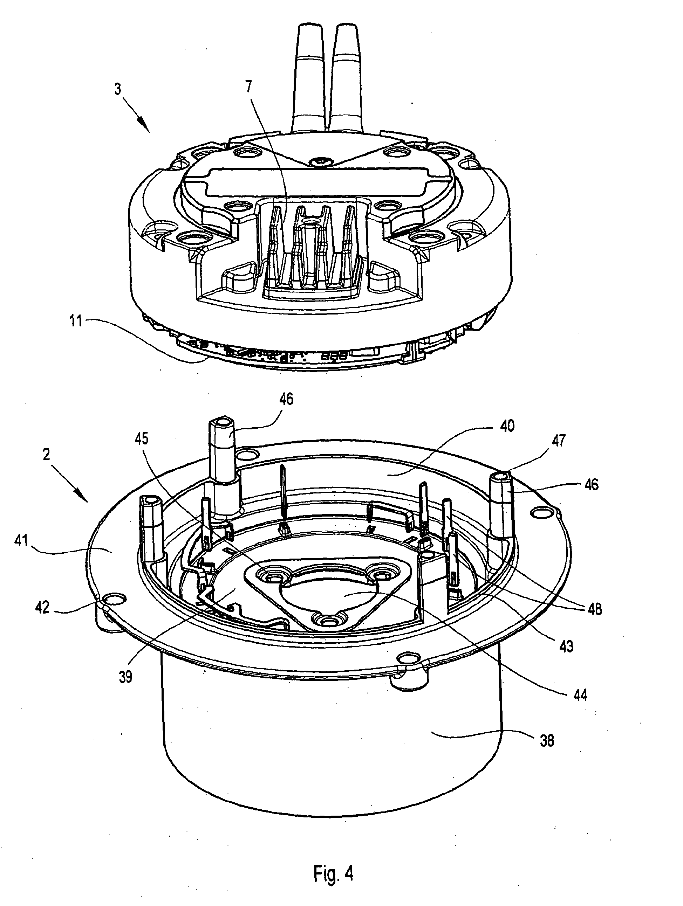

Fig. 4 zeigt eine zweite erfindungsgemäße Ausführungsform, wobei hier das Elektronikgehäuse 1 in zwei Teilen 2, 3 mit einem schematisch angedeuteten Stator 38 eines Elektromotors dargestellt ist. Das Gehäuseoberteil 3, der Kühlkörper 7, das Wärmeleit-Pad 17 und die Leiterplatte 11 bilden eine Vormontageeinheit. Das am Stator 38 befestigte napfförmige Gehäuseunterteil 2 besteht aus einer Bodenwand 39 und einer Umfangswandung 40. Die Umfangswandung 40 besitzt einen senkrecht zur Umfangswandung 40 ausgebildeten, umfänglich verlaufenden Statorflansch 41 mit mehreren Bohrungen 42 zum Befestigen der gesamten Einheit, bestehend aus Elektronikgehäuse 1 mit den Teilen 2, 3, dem Stator 38 und dem nicht dargestellten Rotor an einer nicht dargestellten Befestigungsfläche. Außerdem weist der Statorflansch 41 an seiner Innenseite einen parallel zur Umfangswandung 40 verlaufenden Dichtsteg 43 auf. In der Bodenwand 39 befinden sich mittig eine kreisförmige Öffnung 44 zur Aufnahme einer nicht dargestellten Motorwelle und mehrere Löcher 45 zum Befestigen des Stators 38. Das Gehäuseunterteil 2 weist an der dem Gehäuseoberteil 3 zugewandten Seite mehrere Montagedome 46 mit Sacklöchern 47 auf, die zum Verschrauben des Gehäuseunterteils 2 mit dem Gehäuseoberteil 3 dienen. Die Bodenwand 39 bildet eine Schaltscheibe des Elektromotors mit mehreren Kontaktstiften 48 zum Verbinden der nicht dargestellten Motorwicklungen mit der Leiterplatte 11.

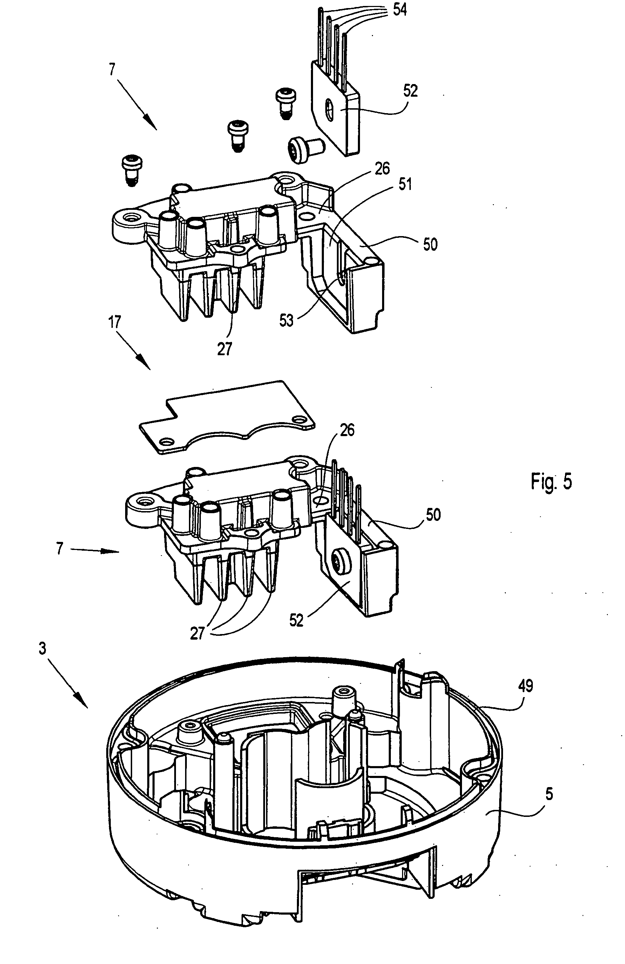

Fig. 5 zeigt eine weitere dreidimensionale Ansicht der zweiten Ausführungsform, wobei das Gehäuseoberteil 3, der Kühlkörper 7 und das Wärmeleit-Pad 17 im nicht montierten Zustand dargestellt sind. Die Seitenwandung 5 weist auf ihrem dem Gehäuseunterteil 2 zugewandten Ende eine Dichtlippe 49 auf. Der Kühlkörper 7 weist einen Halteflansch 50 mit einer zweiten Anlagefläche 51 zur Befestigung von einem zweiten elektronischen Bauteil 52, insbesondere einem Gleichrichter, auf, wobei der Halteflansch 50 seitlich an der Grundplatte 26 mit einem seitlichen Abstand zu den Kühlrippen 27 senkrecht zur Leiterplatte 11 angeformt ist, so dass er seitlich versetzt zur Öffnung 6 innerhalb des Gehäuseoberteils 3 verläuft. Der Halteflansch 50 besitzt in seiner Anlagefläche 51 eine Bohrung 53 zum Befestigen des elektronischen Bauteils 52. Das elektronische Bauteil 52 wird auf dem Halteflansch 50 vormontiert und wird mittels mehrerer Kontaktstifte 54 des elektronischen Bauteils 52 und auf der Leiterplatte 11 befindlicher Kontaktklemmen mit der Leiterplatte 11 bei der Vormontage verbunden. Alternativ kann das elektronische Bauteil 52 auch fest mit der Leiterplatte 11 verlötet und der Halteflansch so positioniert sein, dass durch Verspannungskräfte, die durch die Positionierung der Leiterplatte 11 relativ zum Halteflansch 50 in den Kontaktstiften 54 des elektronischen Bauteils 52 bewirkt werden, das elektronische Bauteil 52 mit seiner Kühlfläche bei der Vormontage der Leiterplatte 11 an die Anlagefläche 51 des Halteflansches 50 des Kühlkörper 7 gedrückt wird oder durch eine nicht dargestellte Klammer an dem Kühlkörper 7 klemmend befestigt wird.

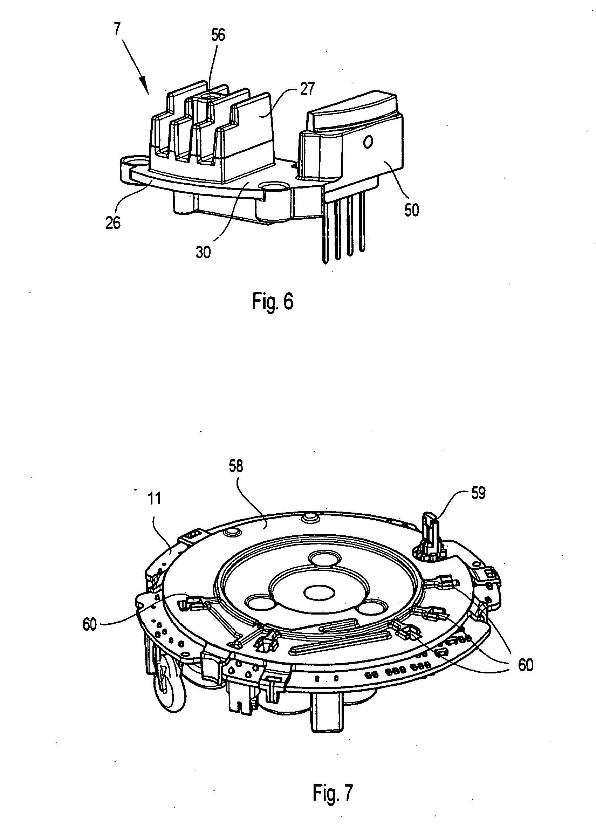

Fig. 6 zeigt einen erfindungsgemäßen Kühlkörper 7 der zweiten Ausführungsform, wobei der Kühlkörper 7 ein Kernloch 56 in oder zwischen den Kühlrippen 27 aufweist, so dass ein nicht dargestellter Schutzerde-Anschluss von außerhalb des Elektronikgehäuses 1 angeschlossen werden kann.

Fig. 7 zeigt eine erfindungsgemäße Leiterplatte 11 der zweiten Ausführungsform, wobei an der dem Gehäuseunterteil 2 zugewandten Seite der Leiterplatte 11 eine Schaltisolationsplatte 58, die gleichzeitig als Fügehilfe zur Montage mit dem Gehäuseunterteil 2 dient, angebracht ist. Die Schaltisolationsplatte 58 weist mehrere Durchbrechungen 60 zum Durchführen der Kontaktstifte 48 der Motorwicklungsanschlüsse des Gehäuseunterteils 2 auf.

Die Erfindung ist nicht auf die dargestellten und beschriebenen Ausführungsbeispiele beschränkt, sondern umfasst auch alle im Sinne der Erfindung gleichwirkenden Ausführungen. Gehäuseoberteil im Sinne der Erfindung kann jeder dem Elektromotor abgewandte Gehäuseabschnitt sein, der zur Lösung der erfindungsgemäßen Aufgabe beiträgt, so dass die Öffnung auch beispielsweise in einer Seitenwandung des Gehäuses ausgebildet sein kann.

## Patentansprüche

1. Elektronikgehäuse (1) für einen Elektromotor, bestehend aus einem mit dem Elektromotor verbindbaren Gehäuseunterteil (2), einer in dem Elektronikgehäuse (1) angeordneten Leiterplatte (11) und einem auf dem Gehäuseunterteil (2) aufgesetzten Gehäuseoberteil (3), wobei in dem Elektronikgehäuse (1) mindestens eine Öffnung (6) für einen im Elektronikgehäuse (1) angeordneten Kühlkörper (7) für ein elektronisches Bauteil (34) vorgesehen ist und die Öffnung (6) im Gehäuseoberteil (3) angeordnet ist und insbesondere das Gehäuseoberteil (3) aus Kunststoff gefertigt ist, wobei das Gehäuseoberteil (3) eine Stirnwand (4) und eine umlaufende Seitenwandung (5) besitzt, **dadurch gekennzeichnet, dass** auf der inneren Seite der Stirnwand (4) ein in den Innenraum ragender domartiger Fortsatz (18) ausgebildet ist und sich die Öffnung (6) in der Stirnseite (19) des Fortsatzes (18) befindet.

2. Elektronikgehäuse nach Anspruch 1,
**dadurch gekennzeichnet, dass** der Kühlkörper (7) eine Grundplatte (26) besitzt und auf der dem Gehäuseoberteil (3) zugewandten Seite mit senkrecht zur Grundplatte (26) verlaufenden Kühlrippen (27) versehen ist, die in die Öffnung (6) des Fortsatzes (18) hineinragen.

3. Elektronikgehäuse nach Anspruch 2,
**dadurch gekennzeichnet, dass** die Grundplatte (26) des Kühlkörpers (7) mit mindestens einem Loch (28) zum Aufstecken des Kühlkörpers (7) auf den Ansatz (20) des Gehäuseoberteils (3) versehen ist.

4. Elektronikgehäuse nach einem der Ansprüche 1 bis 3,
**dadurch gekennzeichnet, dass** der Kühlkörper (7) auf seiner dem Gehäuseoberteil (3) abgewandten Seite der Grundplatte (26) eine Anlagefläche (29) zur Wärmeübertragung aufweist.

5. Elektronikgehäuse nach einem der Ansprüche 1 bis 4,
**dadurch gekennzeichnet, dass** die Öffnung (6) mittels einer Kühlkörperdichtung (19a) zwischen dem Gehäuseoberteil (3) und dem Kühlkörper (7) abgedichtet wird.

6. Elektronikgehäuse nach Anspruch 5,
**dadurch gekennzeichnet, dass** der Kühlkörper (7) auf seiner dem Gehäuseoberteil (3) zugewandten Seite der Grundplatte (26) eine Dichtfläche (30) zum Abdichten der Öffnung (6) aufweist.

7. Elektronikgehäuse (1) nach Anspruch 6,
**dadurch gekennzeichnet, dass** der Kühlkörper (7) in seiner Dichtfläche (30) eine Dichtnut (31) mit einer O-Ring Dichtung aufweist.

8. Elektronikgehäuse (1) nach Anspruch 7,
**dadurch gekennzeichnet, dass** auf der Stirnseite (19) des Fortsatzes (18) eine angespritzte Dichtung (19a), insbesondere aus elastischem Kunststoff, angebracht ist.

9. Elektronikgehäuse (1) nach einem der Ansprüche 1 bis 8,
**dadurch gekennzeichnet, dass** der Kühlkörper (7) mindestens einen Halteflansch (50) mit mindestens einer Anlagefläche (51) zur Befestigung von mindestens einem elektronischen Bauteil (52) aufweist, der seitlich an der Grundplatte (26) mit einem seitlichen Abstand zu den Kühlrippen (27) senkrecht zur Leiterplatte (11) angeformt ist, sodass er seitlich versetzt zur Öffnung (6) innerhalb des Gehäuseoberteils (3) verläuft.

10. Elektronikgehäuse nach Anspruch 9,
**dadurch gekennzeichnet, dass** das elektronische Bauteil (52) fest mit der Leiterplatte (11) verbunden und der Halteflansch (50) so positioniert ist, dass durch Verspannungskräfte, die durch eine leicht versetzte Positionierung des elektronischen Bauteils (52) auf der Leiterplatte (11) relativ zum Halteflansch (50) in den Kontaktstiften (54) des elektronischen Bauteils (52) bewirkt werden, das elektronische Bauteil (52) mit seiner Kühlfläche bei der Vormontage der Leiterplatte (11) an die Anlagefläche (51) des Halteflansches (50) des Kühlkörper (7) gedrückt wird.

11. Elektronikgehäuse nach einem der Ansprüche 1 bis 10,
**dadurch gekennzeichnet, dass** das elektronische Bauteil (52) durch eine Klammer an den Kühlkörper (7) festgeklammert wird.

12. Elektronikgehäuse nach einem der Ansprüche 1 bis 11,
**dadurch gekennzeichnet, dass** das elektronische Bauteil (52) durch eine Schraubverbindung mit dem Kühlkörper (7) verbunden wird.

13. Elektronikgehäuse nach einem der Ansprüche 1 bis 12,
**dadurch gekennzeichnet, dass** die Leiterplatte (11) mit dem Gehäuseoberteil (3) eine lösbare Vormontageeinheit bildet.

14. Elektronikgehäuse nach einem der Ansprüche 1 bis 13,
**dadurch gekennzeichnet, dass** das Gehäuseunterteil (2) aus Kunststoff besteht und den Statorflansch (41) und die Schaltscheibe eines Elektromotors, insbesondere eines Außenläufermotors bildet.

15. Elektromotor bestehend aus einem Rotorteil und einem Statorteil,
**gekennzeichnet durch** ein mit dem Statorteil verbundenes Elektronikgehäuse nach einem der Ansprüche 1 bis 14.

## Claims

1. An electronics housing (1) for an electric motor, consisting of a housing lower-part (2) connectable to the electric motor, a printed circuit board (11) arranged in the electronics housing (1) and a housing upper-part (3) placed upon the housing lower-part (2), wherein at least one opening (6) for a cooling body (7), arranged in the electronics housing (1), for an electronic component (34) is provided in the electronics housing (1) and the opening (6) is arranged in the housing upper-part (3) and in particular the housing upper-part (3) is manufactured from plastics material, wherein the housing upper-apart (3) has an end wall (4) and a circumferential lateral wall (5), **characterised in that** a dome-like protrusion (18) projecting into the interior is formed on the inner side of the end wall (4) and the opening (6) is located in the front face (19) of the protrusion (18).

2. An electronics housing according to claim 1, **characterised in that** the cooling body (7) has a base plate (26) and on the side facing the housing upper-part (3) is provided with cooling ribs (27) running perpendicularly to the base plate (26), which cooling ribs (27) project into the opening (6) of the protrusion (18).

3. An electronics housing according to claim 2, **characterised in that** the base plate (26) of the cooling body (7) is provided with at least one hole (28) for the mounting of the cooling body (7) on the attachment (20) of the housing upper-part (3).

4. An electronics housing according to any one of claims 1 to 3, **characterised in that** the cooling body (7) has, on its side of the base plate (26) remote from the housing upper-part (3), a contact surface (29) for heat transfer.

5. An electronics housing according to any one of claims 1 to 4, **characterised in that** the opening (6) is sealed by means of a cooling-body seal (19a) between the housing upper-part (3) and the cooling body (7).

6. An electronics housing according to claim 5, **characterised in that** the cooling body (7) has, on its side of the base plate (26) facing the housing upper-part (3), a sealing surface (30) for sealing the opening (6).

7. An electronics housing (1) according to claim 6, **characterised in that** in its sealing surface (30), the cooling body (7) has a sealing groove (31) with an O-ring seal.

8. An electronics housing (1) according to claim 7, **characterised in that** an injection-moulded seal (19a), in particular of resilient plastics material, is fitted on the front face (19) of the protrusion (18).

9. An electronics housing (1) according to any one of claims 1 to 8, **characterised in that** the cooling body (7) has at least one holding flange (50) with at least one contact surface (51) for the securing of at least one electronic component (52), which holding flange (50) is formed laterally on the base plate (26), at a lateral distance from the cooling ribs (27) and perpendicular to the printed circuit board (11), so that it runs within the housing upper-part (3) in a manner laterally out-of-line with respect to the opening (6).

10. An electronics housing according to claim 9, **characterised in that** the electronic component (52) is securely connected to the printed circuit board (11) and the holding flange (50) is positioned in such a manner that through tensioning forces brought about in the contact pins (54) of the electronic component (52) by a slight positioning out-of-line of the electronic component (52) on the printed circuit board (11) relative to the holding flange (50), the cooling surface of the electronic component (52) is pressed against the contact surface (51) of the holding flange (50) of the cooling body (7) upon pre-assembly of the printed circuit board (11).

11. An electronics housing according to any one of claims 1 to 10, **characterised in that** the electronic component (52) is clamped to the cooling body (7) by means of a clip.

12. An electronics housing according to any one of claims 1 to 11, **characterised in that** the electronic component (52) is connected to the cooling body (7) by a screw connection.

13. An electronics housing according to any one of claims 1 to 12, **characterised in that** the printed circuit board (11) forms a detachable preassembled unit with the housing upper-part (3).

14. An electronics housing according to any one of claims 1 to 13, **characterised in that** the housing lower-part (2) is composed of plastics material and forms the stator flange (41) and the switch disc of an electronic motor, in particular an external rotor motor.

15. An electric motor consisting of a rotor part and a stator part, **characterised by** an electronics housing, connected to the stator part, according to any one of claims 1 to 14.

## Revendications

1. Boîtier électronique (1) pour un moteur électrique, formé par une partie inférieure (2) apte à être assemblée au moteur électrique, une plaquette de circuits imprimés (11) agencée dans le boîtier électronique (1), et une partie supérieure (3) montée sur la partie inférieure (2), au moins une ouverture (6) étant prévue dans le boîtier électronique (1) pour un corps de refroidissement (7) disposé dans le boîtier électronique (1) et destiné à un composant électronique (34), et l'ouverture (6) est disposée dans la partie supérieure (3), et en particulier la partie supérieure (3) est réalisée en matière plastique, la partie supérieure (3) comportant une face frontale (4) et une paroi latérale (5) périphérique, **caractérisé en ce que** sur la face intérieure de la paroi frontale (4) est réalisé un prolongement (18) en forme de dôme, s'avançant dans le volume intérieur, et l'ouverture (6) se situe dans la face frontale (19) du prolongement (18).

2. Boîtier électronique selon la revendication 1, **caractérisé en ce que** le corps de refroidissement (7) comporte une plaque de base (26) et est muni d'ailettes de refroidissement (27) sur la face orientée vers la partie supérieure (3) du boîtier, lesquelles s'étendent perpendiculairement à la plaque de base (26) et s'engagent dans l'ouverture (6) du prolongement (18).

3. Boîtier électronique selon la revendication 2, **caractérisé en ce que** la plaque de base (26) du corps de refroidissement (7) comporte au moins un trou (28) pour enficher le corps de refroidissement (7) sur la saillie (20) de la partie supérieure (3) du boîtier.

4. Boîtier électronique selon l'une quelconque des revendications 1 à 3, **caractérisé en ce que** le corps de refroidissement (7), sur la face de la plaque de base (26), détournée de la partie supérieure (3) du boîtier, comporte une surface d'appui (29) pour la transmission de chaleur.

5. Boîtier électronique selon l'une quelconque des revendications 1 à 4, **caractérisé en ce que** l'ouverture (6) est rendue étanche par une garniture d'étanchéité (19a) entre la partie supérieure (3) du boîtier et le corps de refroidissement (7).

6. Boîtier électronique selon la revendication 5, **caractérisé en ce que** le corps de refroidissement (7), sur la face de la plaque de base (26), orientée vers la partie supérieure (3) du boîtier, comporte une surface d'étanchéité (30) pour assurer l'étanchéité de l'ouverture (6).

7. Boîtier électronique (1) selon la revendication 6, **caractérisé en ce que** le corps de refroidissement (7), dans sa surface d'étanchéité (30), comporte une rainure (31) avec un joint torique.

8. Boîtier électronique (1) selon la revendication 7, **caractérisé en ce que** sur la face frontale (19) du prolongement (18) est posée une garniture d'étanchéité (19a) injectée sur celle-ci, en particulier en matière plastique élastique.

9. Boîtier électronique (1) selon l'une quelconque des revendications 1 à 8, **caractérisé en ce que** le corps de refroidissement (7) comporte au moins une bride de fixation (50) avec au moins une surface d'appui (51) pour la fixation d'au moins un composant électronique (52), laquelle bride est formée latéralement contre la plaque de base (26) à une distance latérale des ailettes de refroidissement (27) perpendiculairement à la plaquette de circuits imprimés (11), de telle sorte qu'elle est décalée latéralement par rapport à l'ouverture (6) à l'intérieur de la partie supérieure (3) du boîtier.

10. Boîtier électronique selon la revendication 9, **caractérisé en ce que** le composant électronique (52) est assemblé de manière fixe à la plaquette de circuits imprimés (11), et la bride de fixation (50) est positionnée de telle sorte que, sous l'effet de forces de gauchissement, générées dans les plots de contact (54) du composant électronique (52) par un positionnement légèrement décalé du composant électronique (52) sur la plaquette de circuits imprimés (11) par rapport à la bride de fixation (50), le composant électronique (52) est pressé avec sa surface de refroidissement contre la surface d'appui (51) de la bride de fixation (50) du corps de refroidissement (7), au moment du pré-assemblage de la plaquette de circuits imprimés (11).

11. Boîtier électronique selon l'une quelconque des revendications 1 à 10, **caractérisé en ce que** le composant électronique (52) est attaché de manière fixe au corps de refroidissement (7) par une pince.

12. Boîtier électronique selon l'une quelconque des revendications 1 à 11, **caractérisé en ce que** le composant électronique (52) est assemblé au corps de refroidissement (7) par un assemblage vissé.

13. Boîtier électronique selon l'une quelconque des revendications 1 à 12, **caractérisé en ce que** la plaquette de circuits imprimés (11) forme avec la partie supérieure (3) du boîtier une unité pré-assemblée amovible.

14. Boîtier électronique selon l'une quelconque des revendications 1 à 13, **caractérisé en ce que** la partie inférieure (2) du boîtier est réalisée en matière plastique et forme le collet du stator (41) et le disque de commutation d'un moteur électrique, en particulier d'un moteur à induit extérieur.

15. Moteur électrique formé par un élément formant le rotor et un élément formant le stator, **caractérisé par** un boîtier électronique selon l'une quelconque des revendications 1 à 14, assemblé au stator.
